# EUROPEAN PATENT APPLICATION

(11) **EP 4 503 374 A1**
(43) Date of publication of application: **05.02.2025**
(21) Application number: 23885951.6
(22) Date of filing: 18.07.2023
(51) Int. Cl.: H02J 7/00, G06N 20/00, G06F 3/06, G06F 9/455, G06F 8/30, G06F 8/41, G06F 8/65

(54) **BATTERY MANAGEMENT DEVICE AND METHOD, AND BATTERY SYSTEM INCLUDING SAME**

(30) Priority: 04.11.2022 KR 20220146067
(71) Applicant: LG Energy Solution, Ltd., Seoul 07335 (KR)
(72) Inventor: OH, Seung Take, Daejeon 34122 (KR)
(74) Representative: Plasseraud IP
(86) International application number: PCT/KR2023/010271
(87) International publication number: WO 2024/096254

(57) **Abstract**

The battery management apparatus and method, and a battery system including the same according to aembodiments of the present invention may recognize and execute updated control logic from a control logic generator by a virtual machine in real time, thereby enabling execution of updated control logic without stopping the battery management system and providing software capable of highly efficient battery management operation.

## Description

### [Technical Field]

This application claims priority to and the benefit of Korean Patent Application No.10-2022-0146067 filed in the Korean Intellectual Property Office on November 4, 2022, the entire contents of which are incorporated herein by reference.

The present invention relates to an apparatus and method for managing battery and a battery system including the same, and more particularly, to an apparatus and method for managing battery to execute an updated control logic without stopping battery monitoring, the apparatus including a virtual machine and a battery system including the same.

### [Background Art]

An energy storage system relates to renewable energy, batteries that store electric power, and an existing power grid. Recently, as research into smart grid and renewable energy is expanding and the efficiency and the stability of the power system are emphasized, a demand for energy storage systems for power supply and demand control, and power quality improvement is increasing. Depending on a purpose of use, energy storage systems may have different output and capacity. In order to configure a large-capacity energy storage system, a plurality of battery systems may be connected to provide the large-capacity energy storage system.

For example, an energy storage system applied to a photovoltaic (PV) system may include a battery section consisting of multiple batteries, a battery management system for battery management, and a power conversion system (PCS), an energy management system (EMS), a DC-DC(Direct Current-Direct Current) converter.

Among them, the battery management system is a core component that manages batteries and continuous system updates are required to efficiently manage batteries operating at sites.

The conventional battery management system was implemented in such a way that a manager visits the battery installed site in person, stops the operation of the battery system in operation so as to update its software, and then, updates the software.

However, in such a case, compensation due to interruption of use of the battery management system is essential, and an on-site visit must be performed to update the software, resulting in a disadvantage of inefficiency in terms of time and material costs.

### [Detailed Description of the Invention]

### [Technical Problem]

To obviate one or more problems of the related art, embodiments of the present disclosure provide a highly efficient battery management apparatus.

To obviate one or more problems of the related art, embodiments of the present disclosure also provide a highly efficient battery management method.

To obviate one or more problems of the related art, embodiments of the present disclosure also provide a highly efficient battery system.

### [Technical Solution]

In order to achieve the objective of the present disclosure, a battery management apparatus, for operating according to updated control logic without stopping monitoring of charging and discharging of a battery, may include at least one processor; and a memory configured to store at least one instruction executed by the at least one processor, wherein the at least one instruction may include an instruction to control a virtual machine which executes control logic pre-stored in the memory to execute the updated control logic.

Here, the instruction to control the virtual machine to execute the updated control logic may include an instruction to, in the instance that the updated control logic exists in an external storage space connected to the battery management apparatus, execute a loader to copy the updated control logic and store the updated control logic in the memory; and an instruction to operate the virtual machine to parse and execute the updated control logic.

In addition, the at least one instruction may further include an instruction to operate a loader to copy control logic previously stored in an external storage space and store it in the memory; and an instruction to operate the virtual machine execute the pre-stored control logic.

In addition, the at least one instruction may further include an instruction to, upon receiving a termination signal, store the updated control logic in an external storage space and terminate the operation.

Meanwhile, the memory may include a non-volatile memory for storing at least one instruction of the processor; and a volatile memory for storing the pre-stored control logic and the updated control logic.

Here, the volatile memory may include a main memory for storing the pre-stored control logic; and a backup memory for storing the updated control logic.

Meanwhile, the at least one instruction may further include, upon newly updated control logic being stored in the external storage space after the updated control logic before the termination signal is received, an instruction to copy the newly updated control logic and store the newly updated control logic in one of divided areas of the backup memory within the memory; and an instruction to operate the virtual machine to execute the newly updated control logic.

In addition, the pre-stored control logic and the updated control logic may be generated by a control logic generator and compiled into languages which are compatible with the virtual machine.

Meanwhile, The external storage space may be included in a non-volatile storage device including at least one of a hard disk drive (HDD), a flash memory, an electrically erasable programmable read-only memory (EEPROM), and a portable storage device.

In addition, the control logic generator may be connected to the battery management apparatus through a wireless or wired network and transmits the updated control logic to the battery management apparatus.

According to another embodiment of the present disclosure, a battery management method of a battery management apparatus, including a memory and a processor and operating according to updated control logic without stopping monitoring of charging and discharging of a battery, may include controlling a virtual machine which executes control logic pre-stored in the memory to execute the updated control logic.

Here, the controlling the virtual machine to execute the updated control logic may include, in the instance that the updated control logic exists in an external storage space connected to the battery management apparatus, executing a loader to copy the updated control logic and store the updated control logic in the memory; and operating the virtual machine to parse and execute the updated control logic.

The method may further include operating a loader to copy control logic pre-stored in external storage space and store the control logic in the memory; and operating the virtual machine to execute the pre-stored control logic.

The method may further include, upon receiving a termination signal, storing the updated control logic in an external storage space and terminate the operation.

The memory may include a non-volatile memory for storing at least one instruction of the processor; and a volatile memory for storing the pre-stored control logic and the updated control logic.

The volatile memory may include a main memory for storing the pre-stored control logic; and a backup memory for storing the updated control logic.

The method may further include, upon newly updated control logic being stored in the external storage space after the updated control logic before the termination signal is received, copying the newly updated control logic and storing the newly updated control logic in one of divided areas of the backup memory within the memory; and operating the virtual machine to execute the newly updated control logic.

The pre-stored control logic and the updated control logic may be generated by a control logic generator and compiled into languages which are compatible with the virtual machine.

The external storage space may be included in a non-volatile storage device including at least one of a hard disk drive (HDD), a flash memory, an electrically erasable programmable read-only memory (EEPROM), and a portable storage device.

The control logic generator may be connected to the battery management apparatus through a wireless or wired network and transmits the updated control logic to the battery management apparatus.

According to another embodiment of the present disclosure, a battery management system for operating according to updated control logic without stopping monitoring of charging and discharging of a battery, may include a control logic generator configured to generate and compile the updated control logic; and a battery management apparatus, including a processor and a memory, configured to control a virtual machine which executes control logic pre-stored in the memory to execute the updated control logic.

The battery management apparatus may further be configured to, in the instance that the updated control logic exists in an external storage space connected to the battery management apparatus, execute a loader to copy the updated control logic and store the updated control logic in the memory; and operate the virtual machine to parse and execute the updated control logic.

The battery management apparatus may further be configured to operate a loader to copy control logic pre-stored in external storage space and store the control logic in the memory and to operate the virtual machine to execute the pre-stored control logic.

The battery management apparatus may further be configured to, upon receiving a termination signal, store the updated control logic in an external storage space and terminate the operation.

The battery management apparatus is further configured to, upon newly updated control logic being stored in the external storage space after the updated control logic before the termination signal is received, copy the newly updated control logic and store the newly updated control logic in one of divided areas of the backup memory within the memory and operate the virtual machine to execute the newly updated control logic.

The control logic generator may compile the pre-stored control logic and the updated control logic into computer languages which are compatible with the virtual machine.

The the external storage space may be included in a non-volatile storage device including at least one of a hard disk drive (HDD), a flash memory, an electrically erasable programmable read-only memory (EEPROM), and a portable storage device.

The control logic generator may be connected to the battery management apparatus through a wireless or wired network and transmits the updated control logic to the battery management apparatus.

### [Advantageous Effects]

The battery management apparatus and method, and a battery system including the same according to aembodiments of the present invention may recognize and execute updated control logic from a control logic generator by a virtual machine in real time, thereby enabling execution of updated control logic without stopping operation of the battery management system and providing software capable of highly efficient battery management operation.

### [Brief Description of the Drawings]

FIG. 1 is a conceptual diagram of a conventional battery system.
FIG. 2 is a block diagram of an energy storage system to which embodiments of the present invention may be applied.
FIG. 3 is a conceptual diagram of a battery system according to embodiments of the present invention.
FIG. 4 is a block diagram of a battery management apparatus according to embodiments of the present invention.
FIG. 5 is a block diagram of a memory in the battery management apparatus according to embodiments of the present invention.
FIG. 6 is a flowchart for explaining a battery management method according to embodiments of the present invention.

1000: battery management system 1100: control logic generator
1300: battery management apparatus 1500: external storage device
100: memory 110: non-volatile memory
150: volatile memory 151: main memory
155: backup memory 200: processor
300: transceiver 400: Input interface
500: output interface 600: storage device
700: bus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

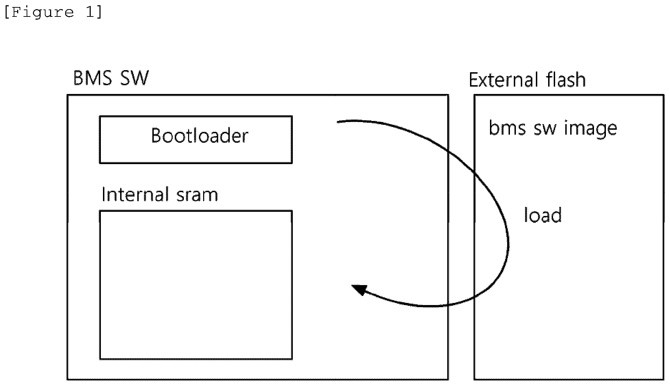

FIG. 1 is a conceptual diagram of a conventional battery system.

Referring to FIG. 1, a general battery system applied to an energy storage system requires continuous system updates to efficiently manage batteries operating at sites.

Accordingly, in order to update the software of a battery management apparatus within the battery system, a manager personally visits the site, stops the operation of the battery system in operation, and performs a software update of the battery management apparatus.

In more detail, since the software update of the conventional battery management apparatus is performed using a compiled image file, it is essential to stop the battery system use in order to apply the compiled image file to the software.

Accordingly, in order to update the software of a conventional battery management apparatus, the existing battery system in operation needs to be stopped, previously compiled executable files remaining in memory are deleted, and the battery management apparatus is initialized.

Afterwards, after switching the battery management apparatus to an update mode, software update is performed through which the updated compile image is copied from an external storage device and stored into a memory by a loader, and the battery management apparatus is initialized to apply the updated compile image to the software program. For example, the external storage device may be a portable storage device.

As described above, in the conventional battery system, interruption of battery system operation is essential so as to apply the updated compile image to the software program, and thus, compensation for interruption in battery use and on-site visits for software updates are required, resulting in a disadvantage of inefficiency in terms of time and material costs.

Accordingly, the battery system according to embodiments of the present invention is presented to obtain updated control logic in real time and reflect the updated control logic to a battery system without system interruption using a virtual machine.

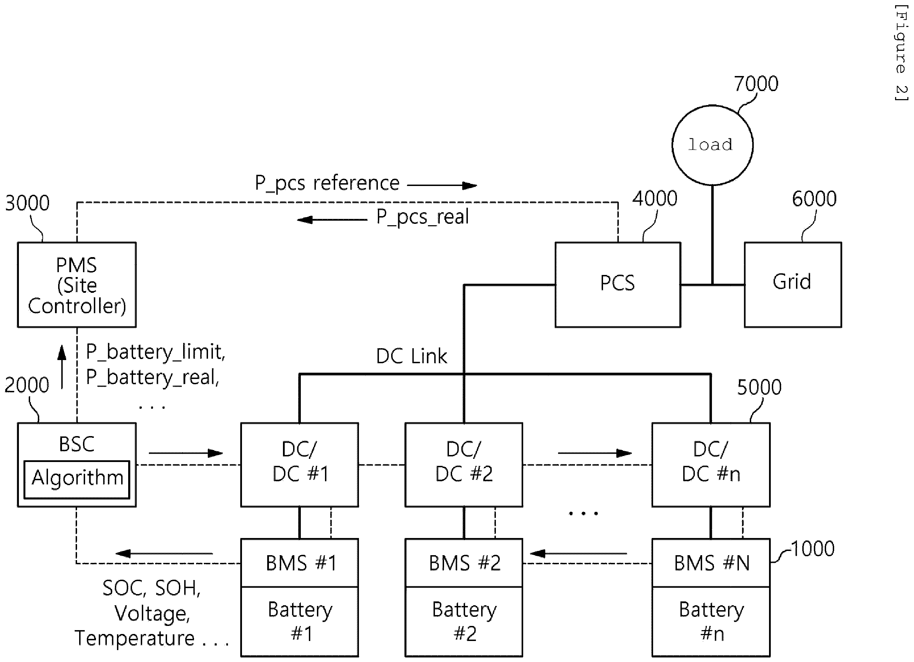

FIG. 2 is a block diagram of an energy storage system to which embodiments of the present invention may be applied.

In an energy storage system (ESS), a battery is used for storing energy or power. Typycally, multiple battery modules may form a battery rack and multiple battery racks form a battery bank. Here, depending on a device or a system in which the battery is used, a battery rack may be referred to as a battery pack. Battery #1, battery #2, ..., and battery #N shown in FIG. 1 may be a battery pack or a battery rack.

Here, a battery management system (BMS) 1000 may be installed for each battery.

The BMS 1000 to which embodiments of the present invention may be applied may monitor a current, a voltage and a temperature of each battery pack (or rack) to be managed, calculate a state Of charge (SOC) of the battery based on a monitoring result to control charging and discharging.

A battery section controller (BSC) 2000 may be located in each battery section which includes a plurality of batteries, peripheral circuits, and devices so as to monitor and control objects in the battery section such as a voltage, a current, a temperature, and a circuit breaker. Furthermore, the BSC 2000 may calculate an output of each DC/DC converter based on the monitored state information of the battery and transmit the calculated output of DC/DC converter to the DC/DC converter.

Furthermore, a power conversion system (PCS) 4000 installed in each battery section may control power supplied from the outside and power supplied from the battery section to the outside, thereby controlling charging and discharging of the battery. The power convertion system may include a DC/AC inverter.

The output of the DC-DC converter 5000 may be connected to the PCS 4000 and the PCS 4000 may be connected to the power grid 6000 and a load 7000. Here, the PCS 4000 typically operates in a constant power mode. A power management system (PMS) 3000 connected to the PCS may control the output of the PCS based on the monitoring and control results of the battery management system or the battery section controller.

In the energy storage system of FIG. 2, battery #1 is connected to DC-DC converter #1, battery #2 is connected to DC-DC converter #2, and battery #N is connected to DC-DC #N. The output of the DC-DC converter corresponding to each battery is connected to the PCS 4000 through a DC link.

The DC-DC converter may be a bidirectional converter, wherein when conversion is performed from the battery to the load direction, the input of the DC-DC converter is connected to a battery (a battery unit, a battery rack or a battery pack) and the output of the DC-DC converter may be connected to a load. As examples of the DC-DC converter, various types of converters such as a full-bridge converter, a half-bridge converter, and a flyback converter may be used.

Meanwhile, communication among the BMS 1000, the BSC 2000, the PMS 3000, and the PCS 4000 may be implemented through a controller area network (CAN) or Ethernet (indicated by a dotted line in FIG. 2).

Hereinafter, preferred embodiments of a battery system applicable to an energy storage system (ESS) according to the present invention will be described in detail with reference to the attached drawings.

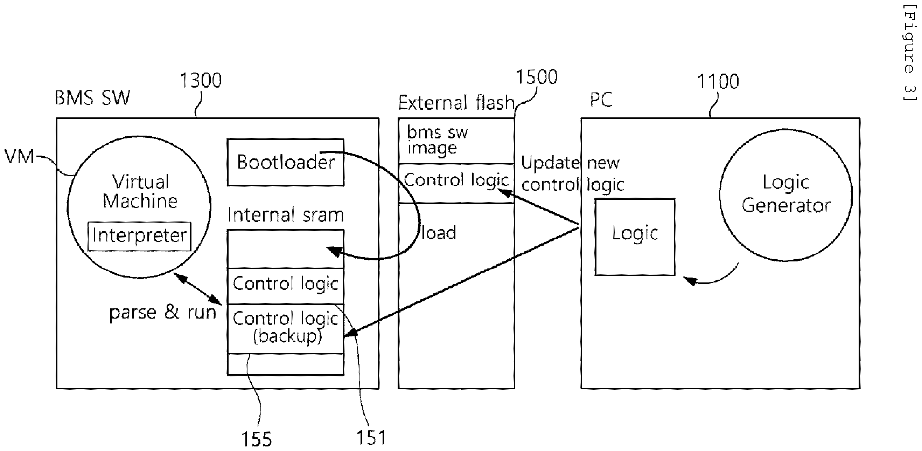

FIG. 3 is a conceptual diagram of a battery system according to embodiments of the present invention.

Referring to FIG. 3, the battery management system 1000 may be applied to an energy storage system (ESS), as described above. Accordingly, the battery management system 1000 may manage the status of batteries which are operated at sites.

According to embodiments, the battery management system 1000 may perform continuous system updates to efficiently manage batteries which are operated at sites.

In more detail, the battery management system 1000 may include a control logic generator 1100 and a battery management apparatus 1300. Additionally, the battery management system 1000 may further include an external storage device 1500.

The control logic generator 1100 may generate control logic to be applied to software of the battery management apparatus 1300, which will be described later, for updating the software of at least one battery system applied to an energy storage system (ESS). According to an embodiment, the control logic generator 1100 may be a supplier PC that is dualized with the battery management apparatus 1300, which will be described later.

Here, the control logic is a program logic for managing state of the battery and may include at least one program logic that requires continuous updating for efficient management of the battery states, such as battery charge/discharge control, cell balancing, and status monitoring. However, the present invention is not limited to the disclosure, and the control logic may be modularized and provided for each program logic.

For example, when the control logic is modularized and provided for each program logic, a virtual machine in the battery management apparatus 1300, which will be described later, may also be provided individually for each module. Accordingly, the modularized control logic and its virtual machine may operate identically to the functions of the control logic and the virtual machine, which will be described later.

The control logic generator 1100 may include a compiler. Accordingly, the control logic generator 1100 may execute the operation of the compiler and compile the generated control logic into a computer language compatible with a virtual machine (VM) in the battery management apparatus 1300, which will be described later. Accordingly, an interpreter of the virtual machine (VM) in the battery management apparatus 1300, which will be described later, may execute the updated control logic generated by the control logic generator 1100. However, without being limited to the disclosure, compilation of the updated control logic may also be performed by an external storage device 1500, which will be described later.

The battery management apparatus 1300 may obtain the updated control logic generated by the control logic generator 1100.

According to an embodiment, the battery management apparatus 1300 may be connected to the control logic generator 1100 through a wired or wireless network. Accordingly, the battery management apparatus 1300 may receive the updated control logic from the control logic generator 1100 through network communication.

According to another embodiment, the battery management apparatus 1300 may obtain the updated control logic using an external storage device 1500, which will be described later.

In more detail, the external storage device 1500 may be physically connected through ports to the control logic generator 1100 and the battery management apparatus 1300. In other words, the external storage device 1500 may be physically connected to the control logic generator 1100 and download the updated control logic generated by the control logic generator 1100. Thereafter, the external storage device 1500 beccomes physically connected to the battery management apparatus 1300 and, when the battery management apparatus 1300 recognizes the external storage device 1500, the battery management apparatus 1300 may operates a loader to copy the updated control logic stored in the external storage device 1500 and temporarily store the updated control logic into the memory of the battery management apparatus 1300. Here, the loader may be a bootloader.

The battery management apparatus 1300 may include a virtual machine (VM). Accordingly, the battery management apparatus 1300 may execute the control logic stored in the memory by operating the virtual machine (VM) using a processor to be described later.

According to embodiments, the battery management apparatus 1300 may execute control logic which is pre-stored in at least one storage space, during its initial operation.

Thereafter, when the updated control logic is obtained, the battery management apparatus 1300 may store the updated control logic in a backup memory area in the memory by a loader and operate the virtual machine (VM) to execute the updated control logic. For example, the virtual machine (VM) may run an interpreter to parse and execute the updated control logic. Here, as described above, the updated control logic may be provided by being compiled, from the control logic generator 1100, into a computer language compatible with the interpreter in the virtual machine (VM), and thus, driving by the interpreter is possible.

As described above, the external storage device 1500 may be a storage device that stores at least one piece of data. According to an embodiment, the external storage device 1500 may be a non-volatile storage device provided in a form of physical hardware. For example, the external storage device 1500 may be provided in a form of at least one of a hard disk drive (HDD), flash memory, electrically erasable programmable read-only memory (EEPROM), and a portable storage device.

Accordingly, the external storage device 1500 may temporarily store the updated control logic generated by the control logic generator 1100 and transmit it to the battery management apparatus 1300.

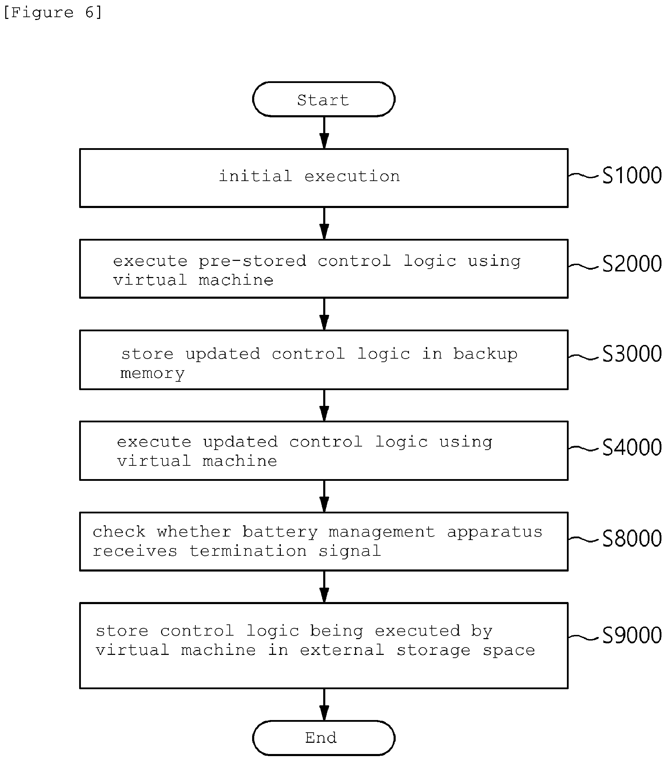

Additionally, the external storage device 1500 may store control logic which is executed by a virtual machine (VM) from the battery management apparatus 1300 before the battery management apparatus 1300 is terminated. Here, the control logic executed by the virtual machine (VM) may be copied by a loader and operated in a main memory within the memory when the battery management apparatus 1300 is re-executed. A battery management method according to the operation of the battery management apparatus will be explained in more detail in FIG. 6, which will be described later.

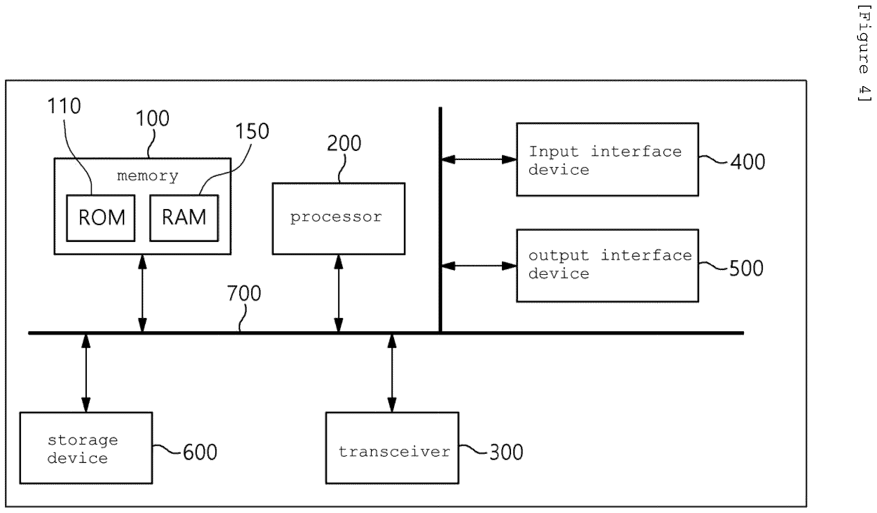

FIG. 4 is a block diagram of a battery management apparatus according to embodiments of the present invention.

Referring to FIG. 4, the battery management apparatus 1300 may include a memory 100, a processor 200, a transceiver 300, an input interface 400, an output interface 500, and a storage device 600. Here, the processor 200 may be a control unit (for example, a microcontroller unit (MCU) of FIG. 2) of a battery pack and a battery rack according to embodiments of the present invention.

According to embodiments, respective components 100, 200, 300, 400, 500, and 600 included in the battery management apparatus 1100 are connected by a bus 700 and can communicate with one another.

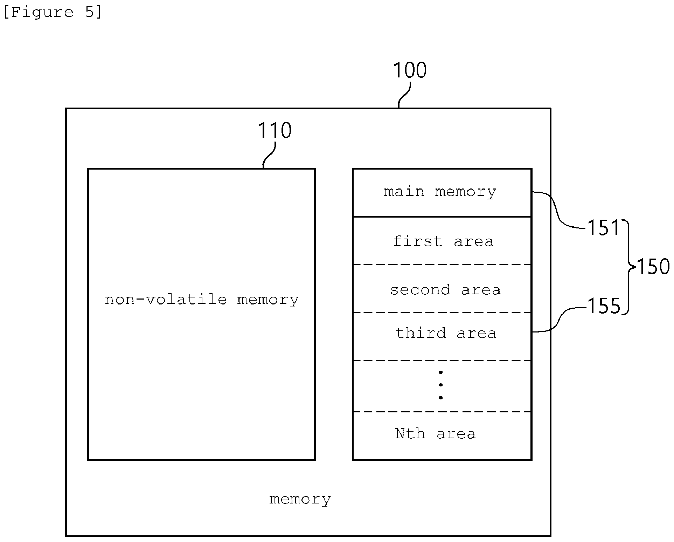

Among the components 100, 200, 300, 400, 500, and 600 of the battery management apparatus 1300, the memory 100 and the storage device 600 may include at least one of a volatile storage medium and a non-volatile storage medium. For example, the memory 100 may include at least one of read only memory (ROM) and random access memory (RAM). The memory 100 will be described in more detail in FIG. 5 below.

The processor 200 may refer to a central processing unit (CPU), a graphics processing unit (GPU), or a dedicated processor on which methods according to embodiments of the present invention are performed.

As described above, the processor 200 may execute at least one program command stored in a non-volatile memory within the memory 1100.

FIG. 5 is a block diagram of a memory in the battery management apparatus according to embodiments of the present invention.

Referring to FIG. 5, the memory 100 may include a non-volatile memory 110 and a volatile memory 150.

The non-volatile memory 110 may permanently store at least one piece of data, regardless of program operations of the battery management apparatus.

According to embodiments, the non-volatile memory 110 may include at least one instruction executed by the processor 200 to control the operation of the wireless communication module. For example, the non-volatile memory 110 may be provided as read only memory (ROM), as described above.

At least one instruction in the battery management apparatus may includes at least one insturction to control a virtual machine which is configured to execute control logic pre-stored in the memory to execute the updated control logic.

Here, the instruction to control the virtual machine to execute the updated control logic may include an instruction to, in the instance that the updated control logic exists in an external storage space connected to the battery management apparatus, execute a loader to copy the updated control logic and store the updated control logic in the memory; and an instruction to operate the virtual machine to parse and execute the updated control logic.

In addition, the at least one instruction may further include an instruction to operate a loader to copy control logic previously stored in an external storage space and store it in the memory; and an instruction to operate the virtual machine execute the pre-stored control logic.

In addition, the at least one instruction may further include an instruction to, upon receiving a termination signal, store the updated control logic in an external storage space and terminate the operation.

Meanwhile, the memory may include a non-volatile memory for storing at least one instruction of the processor; and a volatile memory for storing the pre-stored control logic and the updated control logic.

Here, the volatile memory may include a main memory for storing the pre-stored control logic; and a backup memory for storing the updated control logic.

Meanwhile, the at least one instruction may further include, upon newly updated control logic being stored in the external storage space after the updated control logic before the termination signal is received, an instruction to copy the newly updated control logic and store the newly updated control logic in one of divided areas of the backup memory within the memory; and an instruction to operate the virtual machine to execute the newly updated control logic.

In addition, the pre-stored control logic and the updated control logic may be generated by a control logic generator and compiled into languages which are compatible with the virtual machine.

The external storage space may be included in a non-volatile storage device including at least one of a hard disk drive (HDD), a flash memory, an electrically erasable programmable read-only memory (EEPROM), and a portable storage device.

Meanwhile, the control logic generator may be connected to the battery management apparatus through a wireless or wired network and transmits the updated control logic to the battery management apparatus.

Meanwhile, the volatile memory 150 may temporarily store pre-stored control logic and updated control logic.

According to embodiments, the volatile memory 150 may include a main memory 151 and a backup memory 155.

The main memory 151 may temporarily store pre-stored control logic. In more detail, the main memory 151 may be a space for storing pre-stored control logic copied from an external storage space by a loader during the initial operation of the battery management apparatus 1300. Accordingly, the battery management apparatus 1300 may execute control logic previously stored in the main memory 151 by a virtual machine (VM) during the initial operation by initialization. Here, the control logic pre-stored in the main memory 151 may be the latest updated control logic executed before initialization of the battery management apparatus 1300, as described above.

The backup memory 155 may temporarily store newly updated control logic. To be more specific, the backup memory 155 may store the updated control logic obtained from the control logic generator 1100 by the loader.

The backup memory 155 may store at least one updated control logic obtained from the control logic generator 1100 before a termination signal of the battery management apparatus 1300 is received, that is, before initialization of the battery management apparatus 1300 is performed.

According to an embodiment, the backup memory 155 may be provided with a number of divided areas corresponding to a number of updated control logics, or may be provided as being divided into a number preset by a user in consideration of memory capacity. Accordingly, even when a plurality of updated control logics are provided from the control logic generator 1100 before the battery management apparatus 1300 is initialized, the updated control logics may be sequentially stored in divided areas of the backup memory 155. Therefore, the battery management apparatus 1300 according to embodiments of the present invention may sequentially store newly updated control logics in the backup memory 155, regardless of whether initialization is performed, so that an interpreter of the virtual machine (VM) can execute a corresponding control logic whenever a new updated control logic is stored, which allows software update of the battery management apparatus without interruption of the battery system.

In the above, a battery management apparatus and method according to an embodiment of the present invention, and a battery system including the same have been described. In the following, the battery management method using the processor operation of the battery management apparatus will be described in more detail.

FIG. 6 is a flowchart for explaining a battery management method according to embodiments of the present invention.

Referring to FIG. 6, the battery management apparatus 1300 may be initially executed by operation of a processor 200 (S1000).

The battery management apparatus 1300 may execute a loader. Accordingly, the battery management apparatus 1300 may copy a control logic previously stored in an external storage space by a loader and temporarily store the control logic in a main memory 151.

Afterwards, the battery management apparatus 1300 may run a virtual machine (VM). Accordingly, the interpreter of the virtual machine (VM) may manage the battery by parsing and executing the control logic stored in the main memory 151 (S2000). Here, the control logic may be the latest updated control logic executed immediately before the initial execution of the battery management apparatus 1300. In other words, the battery management apparatus 1300 may operate with the latest software during its initial operation.

The battery management apparatus 1300 may check the external storage space connected to the battery management apparatus 1300 to determine whether any updated control logic exists. Here, the external storage space may be a non-volatile storage medium.

According to one embodiment, the battery management apparatus 1300 may check whether updated control logic exists in the external storage device 1500 physically connected through ports. For example, the external storage device 1500 may be provided in a form of physical hardware such as a hard disk drive (HDD), a flash memory, an electrically erasable programmable read-only memory (EEPROM), and a portable storage device.

According to another embodiment, the battery management apparatus 1300 may check whether updated control logic exists in an external server or a cloud storage connected to a wired or wireless network.

If an updated control logic exists, the battery management apparatus 1300 may execute the loader and store the updated control logic in the backup memory 155 (S3000).

Afterwards, the virtual machine (VM) in the battery management apparatus 1300 may execute an interpreter to parse and execute the updated control logic stored in the backup memory 155 (S4000).

Thereafter, when the battery management apparatus 1300 receives a termination signal from the outside (S8000), the battery management apparatus may store the updated control logic being executed by the virtual machine (VM) in the external storage space (S9000) and terminate the update operation.

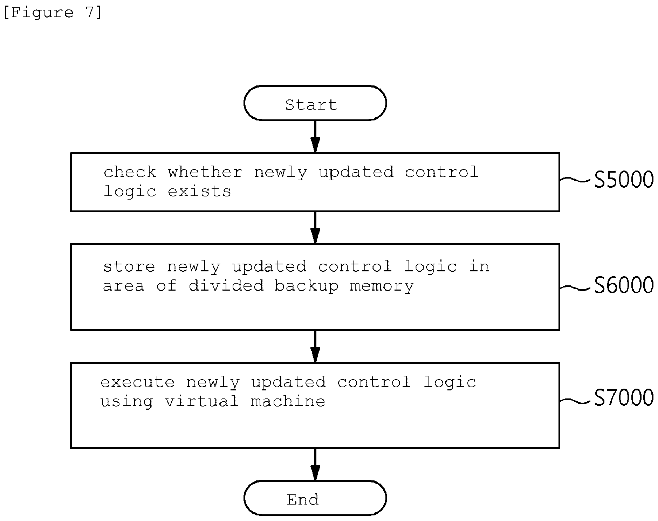

FIG. 7 is a flowchart illustrating an embodiment of the battery management method when there is a newly updated control logic after the updated control logic according to embodiments of the present invention.

Referring to FIG. 7, after execution of the updated control logic and before a termination signal is received from the outside, if a newly updated control logic exists (S5000), the battery management apparatus 1300 may execute the loader to copy newly updated control logic and store the newly updated control logic in an area where the control logic being executed is not stored among the divided areas of the backup memory 155 (S6000).

Accordingly, the interpreter of the virtual machine in the battery management apparatus 1300 may parse and execute the newly updated control logic stored in the divided backup memory 155 (S7000).

Thereafter, as shown in FIG. 6, upon receiving a termination signal from the outside (S8000), the battery management apparatus 1300 may store the updated control logic being executed by the virtual machine (VM) in the external storage space (S9000) and terminatee the update operation.

Referring again to FIG. 6, the battery management apparatus 1300 according to embodiments of the present invention is not limited to what has been described, but may store the updated control logic in an external storage space during idle time occuring at each battery diagnosis cycle, when executing the control logic updated by the virtual machine (VM) in step S4000.

In more detail, the control logic executed by the virtual machine (VM) performs battery diagnosis at a preset cycle in general. In other words, battery diagnosis may be completed within a preset cycle. For example, if the preset cycle is 1 second (sec), the battery diagnosis period may be 0.4 (sec). In other words, an idle time period of 0.6 seconds may occur.

Accordingly, the battery management apparatus 1300 according to embodiments of the present invention may utilize the idle time to store the updated control logic in the external storage space.

For example, the battery management apparatus 1300 may store the updated control logic in several steps in the external storage space during the idle time secured for each battery diagnosis cycle.

According to an embodiment, when the battery management apparatus 1300 completes saving the updated control logic to the external storage space before a termination signal is received from the outside, the battery management apparatus 1300 may skip step S9000 and terminate.

According to another embodiment, the battery management apparatus 1300 may complete storing the remaining unsaved portion of the control logic in the S9000 when storage of the updated control logic into the external storage space is not completed before a termination signal is received from the outside.

Meanwhile, while the updated control logic according to the idle time is being stored, as in S5000, when a newly updated control logic is recognized, the battery management apparatus 1300 may delete the updated control logic previously stored in the external storage space at each idle time.

Thereafter, when deletion of the updated control logic is completed, the battery management apparatus 1300 may store the newly updated control logic in the external storage space.

For example, the battery management apparatus 1300 may store the newly updated control logic in several steps in the external storage space during the idle time secured for each battery diagnosis cycle.

According to one embodiment, when the battery management apparatus 1300 completes saving the newly updated control logic into the external storage space before a termination signal is received from the outside, the battery management apparatus 1300 may skip step S9000 and terminate.

According to another embodiment, the battery management apparatus 1300 may complete storing the remaining unsaved portion of the control logic in step S9000, when storage of the newly updated control logic in the external storage space is not completed before a termination signal is received from the outside.

Therefore, the battery management apparatus according to embodiments of the present invention may first store the updated control logic during idle time that occurs during each battery diagnosis cycle, so that when a termination signal is received from the outside, quick updating of the updated control logic into the external storage space and shortening of storage time is possible.

The battery management apparatus and method, and a battery system including the same according to aembodiments of the present invention have been described above.

The battery management apparatus and method, and a battery system including the same according to aembodiments of the present invention may recognize and execute updated control logic from a control logic generator by a virtual machine in real time, thereby enabling execution of updated control logic without stopping the battery management system and providing software capable of highly efficient battery management operation.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer-readable recording medium may include hardware devices specially configured to store and execute program instructions, such as ROM, RAM, flash memory, etc. The program instructions may include not only machine language code created by a compiler, but also high-level language code that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A battery management apparatus for operating according to updated control logic without stopping monitoring of charging and discharging of a battery, the battery management apparatus comprising:
at least one processor; and
a memory configured to store at least one instruction executed by the at least one processor,
wherein the at least one instruction includes:
an instruction to control a virtual machine which executes control logic pre-stored in the memory to execute the updated control logic.

2. The battery management apparatus of claim 1, wherein the instruction to control the virtual machine to execute the updated control logic includes:
in the instance that the updated control logic exists in an external storage space connected to the battery management apparatus,
an instruction to execute a loader to copy the updated control logic and store the updated control logic in the memory; and
an instruction to operate the virtual machine to parse and execute the updated control logic.

3. The battery management apparatus of claim 1, wherein the at least one instruction further includes:
an instruction to operate a loader to copy the control logic pre-stored in external storage space and store the control logic in the memory; and
an instruction to operate the virtual machine to execute the pre-stored control logic.

4. The battery management apparatus of claim 1, wherein the at least one instruction further includes an instruction to, upon receiving a termination signal, store the updated control logic in an external storage space and terminate the operation.

5. The battery management apparatus of claim 2, wherein the memory includes:
a non-volatile memory for storing at least one instruction of the processor; and
a volatile memory for storing the pre-stored control logic and the updated control logic.

6. The battery management apparatus of claim 5, wherein the volatile memory includes:
a main memory for storing the pre-stored control logic; and
a backup memory for storing the updated control logic.

7. The battery management apparatus of claim 6, wherein the at least one instruction further includes:
upon newly updated control logic being stored in the external storage space after the updated control logic before the termination signal is received,
an instruction to copy the newly updated control logic and store the newly updated control logic in one of divided areas of the backup memory within the memory; and
an instruction to operate the virtual machine to execute the newly updated control logic.

8. The battery management apparatus of claim 2, wherein the pre-stored control logic and the updated control logic are generated by a control logic generator and compiled into languages which are compatible with the virtual machine.

9. The battery management apparatus of claim 2, wherein the external storage space is included in a non-volatile storage device including at least one of a hard disk drive, a flash memory, an electrically erasable programmable read-only memory, and a portable storage device.

10. The battery management apparatus of claim 8, wherein the control logic generator is connected to the battery management apparatus through a wireless or wired network and transmits the updated control logic to the battery management apparatus.

11. A battery management method of a battery management apparatus including a memory and a processor and operating according to updated control logic without stopping monitoring of charging and discharging of a battery, the battery management method comprising:
controlling a virtual machine which executes control logic pre-stored in the memory to execute the updated control logic.

12. The battery management method of claim 11, wherein the controlling the virtual machine to execute the updated control logic includes:
in the instance that the updated control logic exists in an external storage space connected to the battery management apparatus, executing a loader to copy the updated control logic and store the updated control logic in the memory; and
operating the virtual machine to parse and execute the updated control logic.

13. The battery management method of claim 11, further comprising:
operating a loader to copy control logic pre-stored in external storage space and store the control logic in the memory; and
operating the virtual machine to execute the pre-stored control logic.

14. The battery management method of claim 11, further comprising:
upon receiving a termination signal,
storing the updated control logic in an external storage space and terminate the operation.

15. The battery management method of claim 12, wherein the memory includes:
a non-volatile memory for storing at least one instruction of the processor; and
a volatile memory for storing the pre-stored control logic and the updated control logic.

16. The battery management method of claim 15, wherein the volatile memory includes:
a main memory for storing the pre-stored control logic; and
a backup memory for storing the updated control logic.

17. The battery management method of claim 16, further comprising:
upon newly updated control logic being stored in the external storage space after the updated control logic before the termination signal is received,
copying the newly updated control logic and storing the newly updated control logic in one of divided areas of the backup memory within the memory; and
operating the virtual machine to execute the newly updated control logic.

18. The battery management method of claim 12, wherein the pre-stored control logic and the updated control logic are generated by a control logic generator and compiled into languages which are compatible with the virtual machine.

19. The battery management method of claim 12, wherein the external storage space is included in a non-volatile storage device including at least one of a hard disk drive, a flash memory, an electrically erasable programmable read-only memory, and a portable storage device.

20. The battery management method of claim 12, wherein the control logic generator is connected to the battery management apparatus through a wireless or wired network and transmits the updated control logic to the battery management apparatus.

21. A battery system for operating according to updated control logic without stopping monitoring of charging and discharging of a battery, the battery system comprising:
a control logic generator configured to generate and compile the updated control logic; and
a battery management apparatus, including a processor and a memory, configured to control a virtual machine which executes control logic pre-stored in the memory to execute the updated control logic.

22. The battery system of claim 21, wherein the battery management apparatus is further configured to, in the instance that the updated control logic exists in an external storage space connected to the battery management apparatus, execute a loader to copy the updated control logic and store the updated control logic in the memory; and operate the virtual machine to parse and execute the updated control logic.

23. The battery system of claim 21, wherein the battery management apparatus is further configured to operate a loader to copy the control logic pre-stored in external storage space and store the control logic in the memory and to operate the virtual machine to execute the pre-stored control logic.

24. The battery system of claim 21, wherein the battery management apparatus is further configured to, upon receiving a termination signal, store the updated control logic in an external storage space and terminate the operation.

25. The battery system of claim 24, wherein the battery management apparatus is further configured to, upon newly updated control logic being stored in the external storage space after the updated control logic before the termination signal is received, copy the newly updated control logic and store the newly updated control logic in one of divided areas of a backup memory within the memory and operate the virtual machine to execute the newly updated control logic.

26. The battery system of claim 22, wherein the control logic generator compiles the pre-stored control logic and the updated control logic into computer languages which are compatible with the virtual machine.

27. The battery system of claim 22, wherein the external storage space is included in a non-volatile storage device including at least one of a hard disk drive , a flash memory, an electrically erasable programmable read-only memory, and a portable storage device.

28. The battery system of claim 21, wherein the control logic generator is connected to the battery management apparatus through a wireless or wired network and transmits the updated control logic to the battery management apparatus.
